# EUROPEAN PATENT SPECIFICATION

(11) **EP 1 035 675 B1**
(45) Date of publication and mention of the grant of the patent: **25.03.2009**
(21) Application number: 98938955.6
(22) Date of filing: 24.08.1998
(51) Int. Cl.: H04L 27/26, H04L 27/00

(54) **Signal modulator and receiving control method for the signal modulator**
Signalmodulator und Empfangskontrollverfahren für den Signalmodulator
Modulateur de signaux et procédé de commande de réception associé

(43) Date of publication of application: 13.09.2000
(73) Proprietor: MITSUBISHI DENKI KABUSHIKI KAISHA, Chiyoda-ku Tokyo 100-8310 (JP)
(72) Inventor: TAKEUCHI, Mitsuru Mitsubishi Denki K.K., Tokyo 100-8310 (JP); SAKAGUCHI, Tadashi, Mitsubishi Denki Engin. K.K., Tokyo 100-0004 (JP); MORITA, Masakazu Mitsubishi Denki Kabushiki Kaisha, Tokyo 100-8310 (JP)
(74) Representative: Pfenning, Meinig & Partner GbR
(86) International application number: PCT/JP1998/003742
(87) International publication number: WO 2000/011824

(56) References cited:
- EP-A2- 0 840 485
- WO-A-94/26046
- GB-A- 2 313 270
- JP-A- 4 501 348
- JP-A- 7 095 175
- JP-A- 7 143 096

## Description

### BACKGROUND OF THE INVENTION

### Technical Field

The present invention relates to a signal decoding device which is capable of correctly receiving carrier waves necessary for modulated signals such as OFDM (Orthogonal Frequency Division Multiplex) signals configured by a plurality of sub-carriers in a good state, yet without getting into a false locked phenomenon, and also relates to a method of controlling the reception of modulated signals by use of the signal decoding device.

### Background Art

WO 94/26046 describes a receiver for orthogonal frequency multiplexed signals (OFDM) which includes means for calculating the Fourier transform of the received signal and means for calculating the phase error due to local oscillator errors.

In GB 2 313 270 A a digital broadcast receiver is disclosed controlling the local oscillator depending on the frequency deviation. A vector of a fixed pattern symbols for reference of received carriers is multiplied by a vector of conjugate complex numbers of the defined values for each element. In the result, elements separated by the same numbers forward and backward from an element at a particular carrier frequency are multiplied together and the results added. The same processing is applied to cases in which the elements of the vectors are mutually shifted by plurality of elements from a certain correspondence. The broadcasting frequency on the basis of a value maximizing the absolute value in the results of addition and correspondence at that time.

EP 0 840 485 A2 disclosed a method and a circuit for the synchronisation of an OFDM receiver using a dispersion detection of blocks, and a calculation of a ratio dispersions of two blocks, an iteration of ratios and a peak detection for synchronisation.

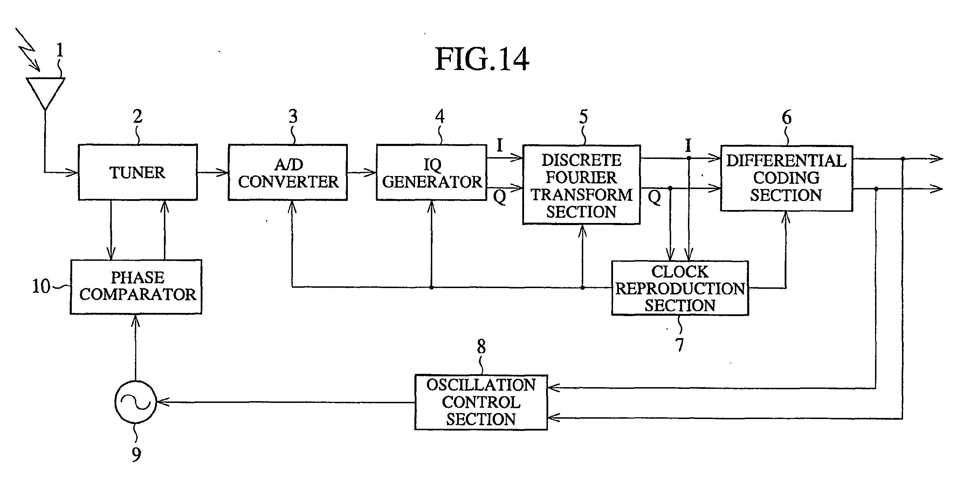

Fig. 14 is a schematic diagram showing a further conventional signal decoding device, which is used for correctly and excellently receiving carrier waves (or may be referred to just as "carriers" hereinafter) necessary for decoding modulated signals configured by a plurality of sub-carriers; specifically for receiving DAB(Digital Audio Broadcasting) signals modulated by the OFDM modulation method. In the figure, reference numeral 2 denotes a tuner that converts a radio wave received through a receiving antenna 1 into a signal of the medium frequency band, numeral 4 denotes an IQ generator section that divides a digital data, which is generated in and fed from an A/D converter 3, into an I signal component (real-number unit) and a Q signal component (imaginary-number unit), and numeral 5 denotes a discrete Fourier transform section that carries out Fourier transformation to these I and Q signal components so as to modulate a time-mode signal to a frequency-mode signal.

Further, reference numeral 6 denotes a differential coding section that calculates the difference between the phase of a carrier configuring the OFDM signal and the phase of the carrier which is one OFDM symbol before that phase from the modulated I signal component data and the Q signal component data as to all the carriers, numeral 7 denotes a clock reproduction section that detects and corrects a timing discrepancy of the synchronization between the transmission side and the reception side, so as to reproduce clock signals without any discrepancy in the synchronization, and controls the A/D converter 3, the IQ generator section 4, the discrete Fourier transform section 5 and the differential coding section 6. Reference numeral 8 denotes an oscillator control section that controls a local oscillator 9 to vary the oscillation frequency in accordance with the phase difference of the carrier, numeral 10 denotes a phase comparator for controlling the tuner 2 so as to equalize the oscillation frequency of the local oscillator 9 and that of a local oscillator contained in the tuner 2.

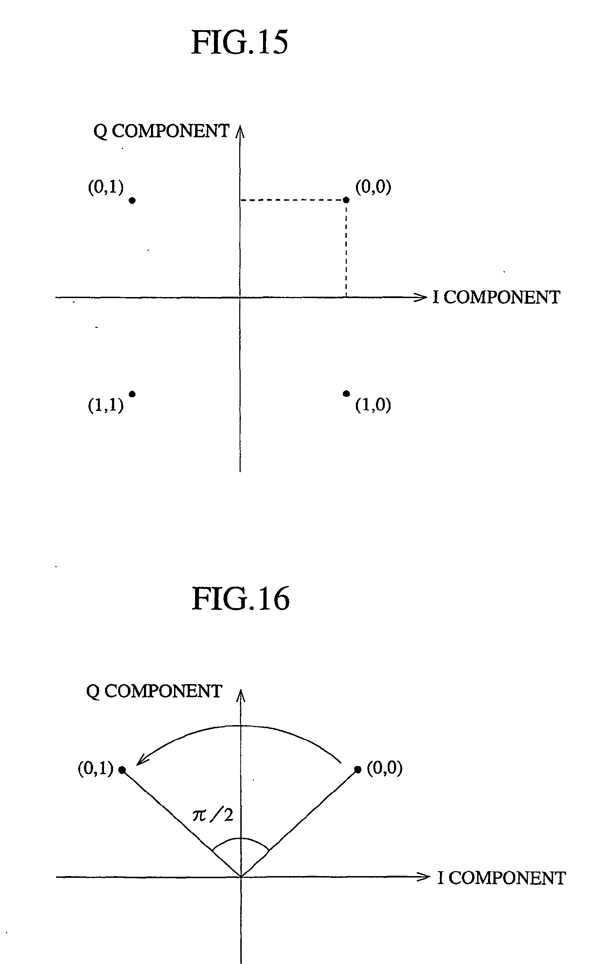

Fig. 15 is an illustration that represents 4 values transmitted in the QPSK (Quadrature Phase Shift Keying) modulation mode, and Fig. 16 is an illustration indicating the state that a carrier has been advanced for π/2 in the QPSK modulation mode. The modulating method of carriers employed in the DAB is of the DQPSK (Differential Quadrature Phase Shift Keying) modulation, whereby the carriers can be represented in digital values; namely I signal component and Q signal component by carrying out the Fourier transformation, and if, as shown in Fig. 15, the axis of abscissa indicates the I signal component, and that of ordinates indicates the Q component, the 4 values (I,Q) can be represented as (0,0), (0,1), (1,0) and (1,1), respectively. That is, the phase error becomes zero at these 4 points.

At this time, if for example, as shown in Fig. 16, the data that has to take the value (I,Q) = (0,0) is shifted for π/2 phase, it coincides with the value (I,Q) = (0,1), and on this occasion the differential coding section 6 judges that there is no discrepancy in phase, in spite of the fact that the data has been shifted for π/2 phase.

The operation of the conventional signal decoding device is as follows.

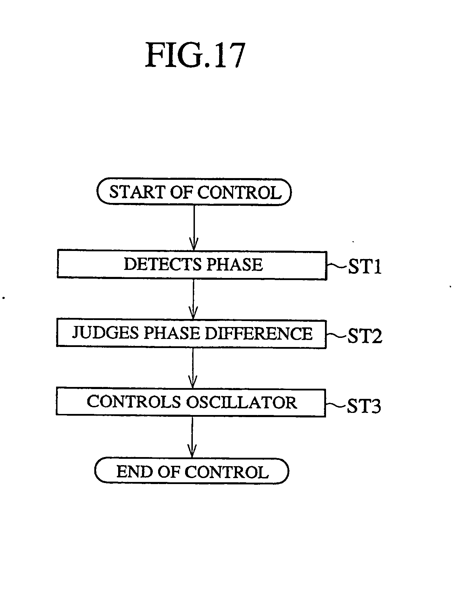

Fig. 17 is a flow chart showing an exemplary case of the control operation for receiving the DAB signals in the conventional signal decoding device.

When the control of synchronization performed in the radio wave signal receiver is started, the differential coding section 6 judges the phase difference by use of the detected phase data input from the discrete Fourier transform section 5 (step ST1), and when it judges that the phase error is π/8 (step ST2), then it outputs a data corresponding to the correction of π/8 to the oscillator control section 8. Thereafter, the oscillator control section 8 controls the local oscillator 9 to carry out synchronization on the basis of the data corresponding to the correction of π/8 (step ST3), and then terminates the control operation. By carrying out these steps at predetermined periods, the signal reception in good condition can be obtained.

However, if the phase error judged in step ST2 by use of the detected phase data is π/2, the detected phase data coincides with the next value of the 4 values {(I,Q) = (0,0), (0,1), (1,0), (1,1)}, and thus it is erroneously judged that it is in the synchronized state, so that the differential coding section 6 does not instruct any correction control. For this reason, the oscillator control section 8 does not perform any correction control of the local oscillator 9, and thus terminates the control operation erroneously. The erroneous judgment is referred to as a "false lock" hereinafter.

Consequently, when there is a phase discrepancy of a carrier for + π/2 for some reason or other during the control operation of the carrier synchronization, the conventional DAB signal receiver 2 would judge that there has been no phase discrepancy.

Since the conventional signal decoding device and a method of controlling the signal reception implemented therein are constructed as such, when a signal including a phase error that could cause the false lock is received, there has been caused such a problem that the signal decoding device could not properly receive the modulated signal without error.

The present invention has been proposed to solve the problems aforementioned, and it is an object of the present invention to provide a signal decoding device which is capable of correctly receiving carriers necessary for PFDM modulated signals in a good state, yet without getting into the false locked state, and also a method of controlling the signal reception implemented therein.

### DISCLOSURE OF THE INVENTION

This object is achieved by the features of the independent claims. The invention discloses a device and a method according to the independent claims. The subject-matter disclosed below in the description and going beyond the scope of the claims has to be considered as examples and not embodiments, even if the words like "embodiment" or "invention" are used in said description.

The signal decoding device according to the present invention is constructed in such a manner as to calculate phase errors from detected phases, detect the dispersed state of the thus calculated phase errors, judge whether or not the decoded signal is of good quality from the detected dispersed state of the phase errors, and output the result of judgment to the oscillator control section.

Due to this, by referring the dispersed state output from the dispersion detection section to the relation between the phase errors and the dispersion thereof in the signal quality judging section so as to judge the signal quality, such an effect can be efficiently obtained that carrier waves required for phase-modulated broadcast signals such as OFDM signals configured by a plurality of sub-carriers can be correctly received in a good state, yet without getting into a false locked phenomenon.

The signal decoding device according to the present invention is constructed in such a manner as to calculate phase errors from the calculated phase differences, detect the dispersed state of the thus calculated phase errors, judge whether or not the decoded signal is of good quality from the detected dispersed state of the phase errors, and output the result of judgment to the oscillator control section.

Due to this, by referring the dispersed state output from the dispersion detection section to the relation between the phase errors and the dispersion thereof in the signal quality judging section so as to judge the signal quality, such an effect can be efficiently obtained that carrier waves required for differential phase-modulated broadcast signals such as OFDM signals configured by a plurality of sub-carriers can be correctly received in a good state, yet without getting into a false locked phenomenon.

The signal decoding device according to the present invention is constructed in such a manner as to calculate phase errors from the calculated phase differences, detect the dispersed state of the thus calculated phase errors in a stepwise manner, judge in a stepwise manner whether or not the decoded signal is of good quality from the detected stepwise dispersed state of the phase errors, output the judgment result, vary the control amount in a stepwise manner in accordance with the judged stepwise qualities when calculating the control amount from the mean value of the phase errors, and vary the oscillation frequency of a local oscillator on the basis of this control amount

Due to this, the signal receiving device can be efficiently controlled by judging the signal quality in a stepwise manner in accordance with the dispersed state of the detected phase errors, and by controlling in a stepwise manner the frequency and the phase of a local oscillation signal used for decoding operation.

The signal decoding device according to the present invention is constructed in such a manner as to feed, for carrying out an audio control, the judgment result of the dispersed state detected in a stepwise manner to an audio control section, which in turn determines a muting amount in accordance with the detection result of the stepwise dispersed state.

Due to this, the signal quality is judged in a stepwise manner in accordance with the dispersed state of the detected phase errors, and the muting amount is controlled on the basis of the result of the judgment, so that such an effect can be obtained that a queer sound generated in accordance with the deterioration of the decoded signal is suppressed.

The signal decoding device according to the present invention is constructed in such a manner that the audio control section determines the control amount of high-pitch tone from the stepwise detection result of the dispersed state,

Due to this, such an effect can be obtained that a queer sound generated in accordance with the deterioration of the decoded signal is suppressed.

The method of controlling the signal reception in the signal decoding device according to the present invention is arranged in such a manner as to calculate phase errors from the calculated phase differences, detect the dispersed state of the thus calculated phase errors, judge whether or not the decoded signal is of good quality from the detected dispersed state of the phase errors, and output the result of judgment to the oscillator control section.

Due to this, by referring the dispersed state output from the dispersion detection section to the relation between the phase errors and the dispersion thereof so as to judge the signal quality, such an effect can be efficiently obtained that carrier waves required for the OFDM signals configured by a plurality of sub-carriers can be correctly received in a good state, yet without getting into a false locked phenomenon.

The method of controlling the signal reception in the decoding device according to the present invention is arranged in such a manner as to calculate phase errors from the calculated phase differences, detect the dispersed state of the thus calculated phase errors in a stepwise manner, judge in a stepwise manner whether or not the decoded signal is of good quality from the detected dispersed state of the phase errors, output the judgment result, vary the control amount in a stepwise manner in accordance with the judged stepwise qualities when calculating the control amount from the mean value of the phase errors, and vary the oscillation frequency of a local oscillator on the basis of the control amount.

Due to this, the signal receiving device can be controlled more efficiently by judging the signal quality in a stepwise manner in accordance with the dispersed state of the detected phase errors, and by controlling in a stepwise manner the frequency and the phase of a local oscillation signal used for decoding operation.

The method of controlling the signal reception in the signal decoding device according to the present invention is arranged in such a manner as to feed, for carrying put an audio control, the judgment result of the dispersed state detected in a stepwise manner to an audio control section; which in turn determines a muting amount in accordance with the detection result of the stepwise dispersed state.

Due to this, the signal quality is judged in a stepwise manner in accordance with the dispersed state of the detected phase errors, and the muting amount is controlled on the basis of the result of the judgment, so that such an effect can be acquired that a queer sound generated in accordance with the deterioration of the decoded signal is suppressed.

The control method of signal reception in the signal decoding device according to the present invention is arranged in such a manner that the audio control section determines the control amount of high-pitch tone from the stepwise detection result of the dispersed state,

Due to this, such an effect can be acquired that a queer sound generated in accordance with the deterioration of the decoded signal is suppressed.

### BRIEF DESCRIPTION OF THE DRAWINGS

Fig. 1 is a schematic diagram showing a signal decoding device according to a first embodiment of the present invention.
Fig. 2 is a flow chart showing an exemplary case of the control operation for receiving the DAB signals carried out in the signal decoding device according to the first embodiment of the present invention.
Fig. 3 is an illustration showing the dispersion of detected phase errors in the case where the level of discrepancy is small in the signal decoding device according to the first embodiment of the present invention.
Fig. 4 is an illustration showing the dispersion of detected phase errors in the case where the level of discrepancy is greater than the case of Fig. 3 in the signal decoding device according to the first embodiment of the present invention.
Fig. 5 is an illustration showing the dispersion of detected phase errors in the case where the level of discrepancy is further greater than the case of Fig. 4 in the signal decoding device according to the first embodiment of the present invention.
Fig. 6 is an illustration showing the relation between the level of discrepancy and detected phase errors in the signal decoding device according to the present invention.
Fig. 7 is a schematic diagram showing a signal decoding device according to a second embodiment of the present invention
Fig. 8 is a flow chart showing an exemplary case of the control operation for receiving the DAB signals in the signal decoding device according to the second embodiment of the present invention.
Fig. 9 is a schematic diagram showing a signal decoding device according to a third embodiment of the present invention
Fig. 10 is a flow chart showing an exemplary case of the control operation for receiving the DAB signals in the signal decoding device according to the third embodiment of the present invention.
Fig. 11 is a schematic diagram showing a signal decoding device according to a fourth embodiment of the present invention
Fig. 12 is a flow chart showing an exemplary case of the control operation for receiving the DAB signals in the signal decoding device according to the fourth embodiment of the present invention.
Fig. 13 is a flow chart showing an exemplary case of the control operation for receiving the DAB signals in the signal decoding device according to the fifth embodiment of the present invention.
Fig. 14 is a schematic diagram showing a conventional signal decoding device.
Fig. 15 is an illustration representing 4 values transmitted in the QPSK modulation mode.
Fig. 16 is an illustration showing the state in which a carrier has been advanced for π/2 in the QPSK modulation mode.
Fig. 17 is a flow chart showing an exemplary case of the control operation for receiving the DAB signals in the conventional signal decoding device.

### BEST MODE FOR CARRYING OUT THE INVENTION

Several embodiments for carrying out best the present invention are now explained with reference to attached drawings, in order to explain the present invention to details.

### [First Embodiment]

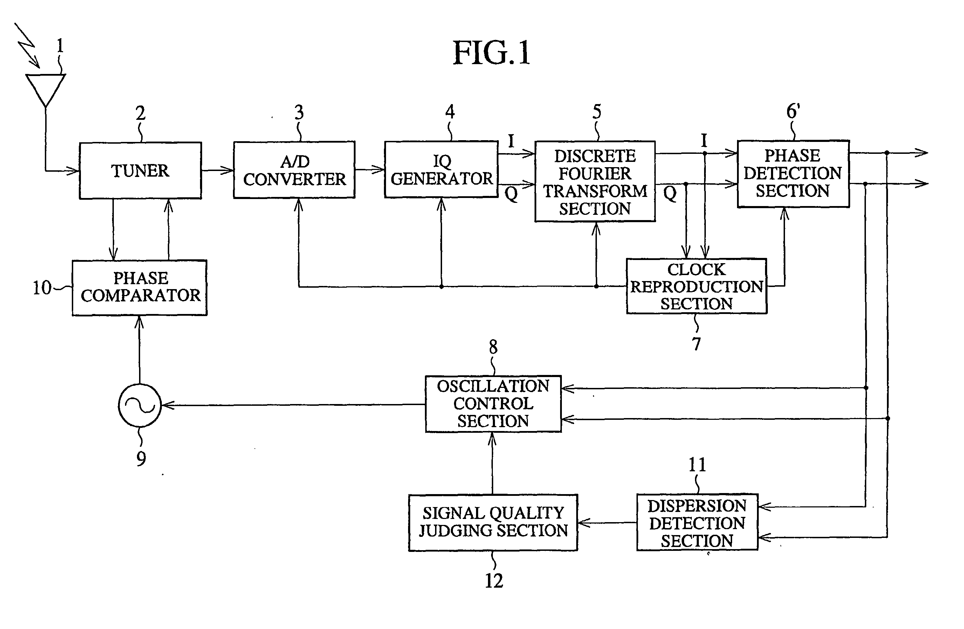

Fig. 1 is a schematic diagram showing a signal decoding device according to a first embodiment of the present invention. In the figure, reference numeral 2 denotes a tuner that converts a radio wave received through a receiving antenna 1 into a signal of the medium frequency band, numeral 4 denotes an IQ generator section that divides a digital data, which is generated in and fed from an A/D converter 3, into an I signal component (real-number unit) and a Q signal component (imaginary-number unit), and numeral 5 denotes a discrete Fourier transform section that carries out Fourier transformation to these I and Q signal components so as to modulate a time-mode signal to a frequency-mode signal. Reference numeral 6' denotes a phase detection section that detects the phase of all the carriers configuring OFDM signals from the frequency-modulated I component data and Q component data, numeral 7 denotes a clock reproduction section that detects and corrects a timing discrepancy of the synchronization between the transmission side and the reception side, so as to reproduce clock signals without any discrepancy in the synchronization, and controls the A/D converter 3, the IQ generator section 4, the discrete Fourier transform section 5 and the phase detection section 6'.

Further, reference numeral 8 denotes an oscillator control section that controls a local oscillator 9 to vary the oscillation frequency in accordance with the phase of the carrier output from the phase detection section 6'. When the oscillator control section 8 calculates a control amount from the mean value of phase errors, it varies the control amount in accordance with the signal quality judged in the signal quality judging section 12. For example, when it is judged in the signal quality judging section 12 that the signal is of good quality, the oscillator control section 8 applies a control amount calculated from the mean value of the phase errors, or otherwise it applies a predetermined control amount (for example an amount corresponding to π/2) irrespective of the control amount calculated from the mean value of the phase errors. Thereafter, the oscillation frequency of the local oscillator 9 is varied in accordance with the control amount fed from the oscillator control section 8.

Reference numeral 10 denotes a phase comparator for controlling the tuner 2 to equalize the oscillation frequency of the local oscillator 9 and that of a local oscillator contained in the tuner 2, numeral 11 denotes a dispersion detection section that detects the dispersed state of the phase errors, which are obtained from the phases calculated beforehand, and numeral 12 denotes a signal quality judging section 12 that judges the quality of the decoded signal on the basis of the dispersed state detected in the dispersion detection section 11, and outputs the result of the judgment to the oscillator control section 8.

The operation of the signal decoding device according to the first embodiment of the present invention is as follows.

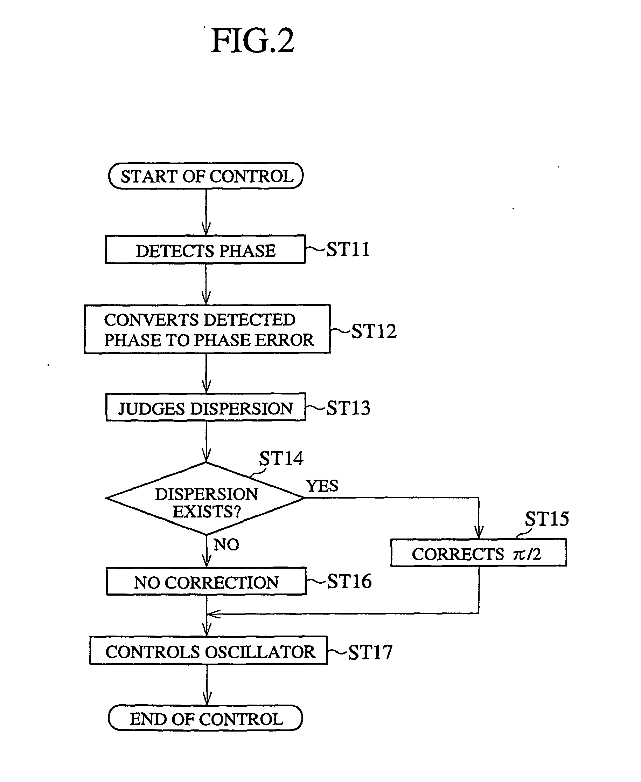

Fig. 2 is a flow chart showing an exemplary case of the control operation for receiving the DAB signals in the signal decoding device according to this embodiment.

When the control of synchronization performed in the radio wave receiver is started, the phase detection section 6' calculates the phase by use of the detected phase data input from the discrete Fourier transform section 5 (step ST11), the dispersion detection section 11 converts the phase fed from the phase detection section 6' into phase errors (step ST12), and the signal quality judging section 12 judges the dispersed state of the phase errors (step ST13).

Thereafter, when the quality judging section 12 checks whether there is a dispersion (step ST14), and judges that it is positive, then it instructs a certain correction control amount (for example π/2) to the oscillator control section 8 (step ST15), whereas when it judges that there is no dispersion, then it instructs no correction control (step ST16). Finally, the oscillator control section 8 terminates the control of the synchronization depending on whether there is an instruction of correction control from the dispersion detection section 11 (step ST17). By carrying out these steps at predetermined periods, the signal reception in good condition can be obtained.

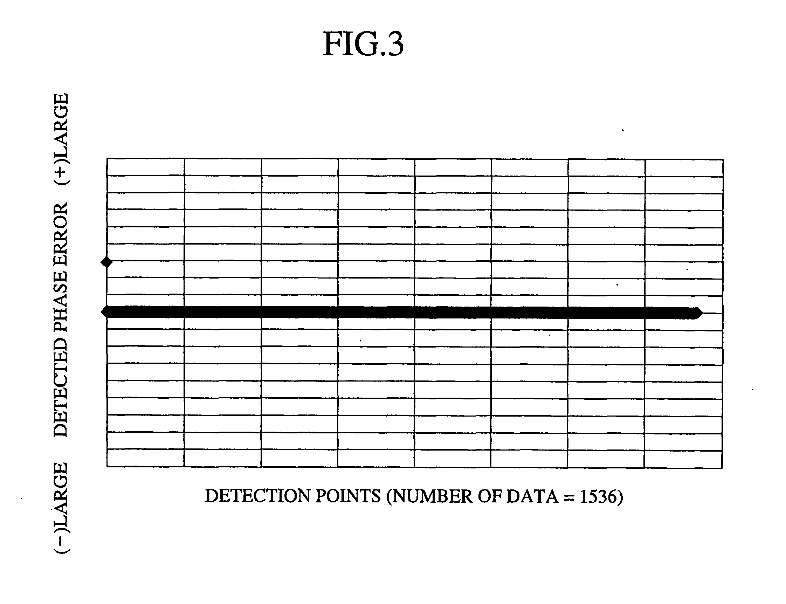

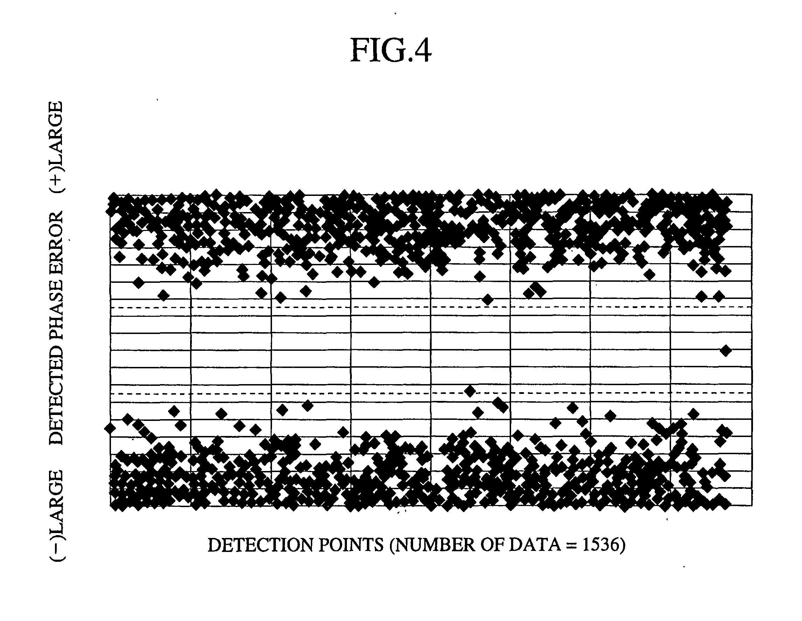

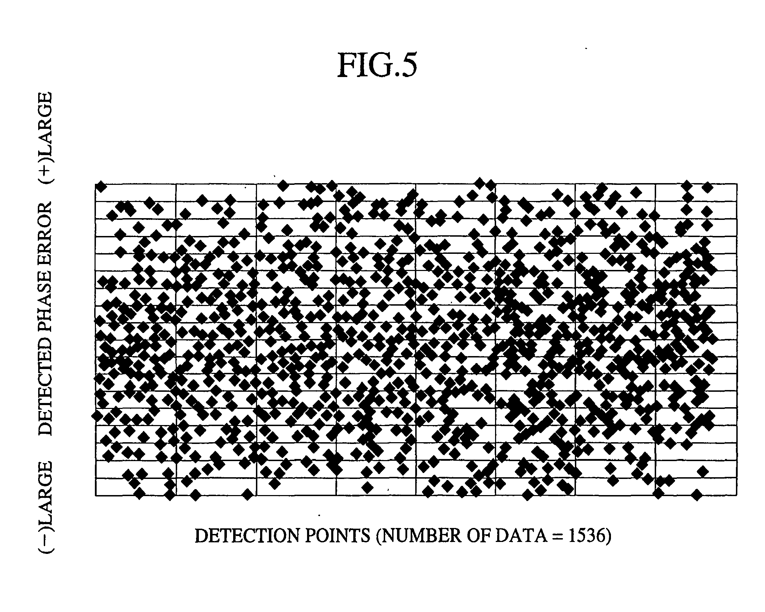

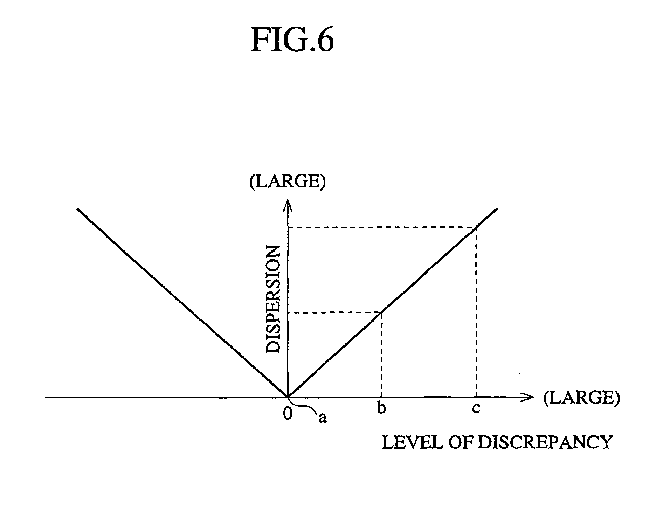

Fig. 3 is an illustration showing the dispersion of detected errors in the case where the level of discrepancy is small in the signal decoding device according to the first embodiment of the present invention, Fig. 4 is an illustration showing the dispersion of detected phase errors in the case where the level of discrepancy is greater than the case of Fig. 3 in the signal decoding device according to the first embodiment of the present invention, Fig. 5 is an illustration showing the dispersion of detected phase errors in the case where the level of discrepancy is further greater than the case of Fig. 4 in the signal decoding device according to the first embodiment of the present invention, and Fig. 6 is an illustration showing the relation between the level of discrepancy and the detected phase errors in the signal decoding device according to the first embodiment of the present invention.

When the discrepancy level of the frequency of the transmission side and that of the reception side is small in the case that OFDM modulation signal is transmitted in compliance with the DAB standard, the detected phase errors depicted per each sampling will be as shown in Fig. 3. Similarly, the case in which the level of discrepancy is greater, and the case in which the level of discrepancy is smaller are as shown in Figs. 4 and 5, respectively, so that the relation between the detected phase errors and the dispersion thereof in the signal decoding device according to the present invention will be as shown in Fig. 6. By use of this relationship, the signal quality can be judged from the dispersed state of the phase errors. For example, when the dispersion is greater than the point b in Fig. 6, it can be judged that the absolute value of the discrepancy is large, so that it can be judged that the signal quality is not good, whereas in the case of the range between a and b, it can be judged that the signal is of good quality.

As explained above, according to the first embodiment, when the signal quality judging section 12 compares the dispersed state input from the dispersion detection section 11 to the relation between the phase errors and the dispersion thereof, it can judge the signal quality, so that in the case where phase-modulated signals such as OFDM signals configured by a plurality of carriers are to be received, carriers necessary for those signals can be correctly received in a good state, yet without getting into a false locked state.

### [Second Embodiment]

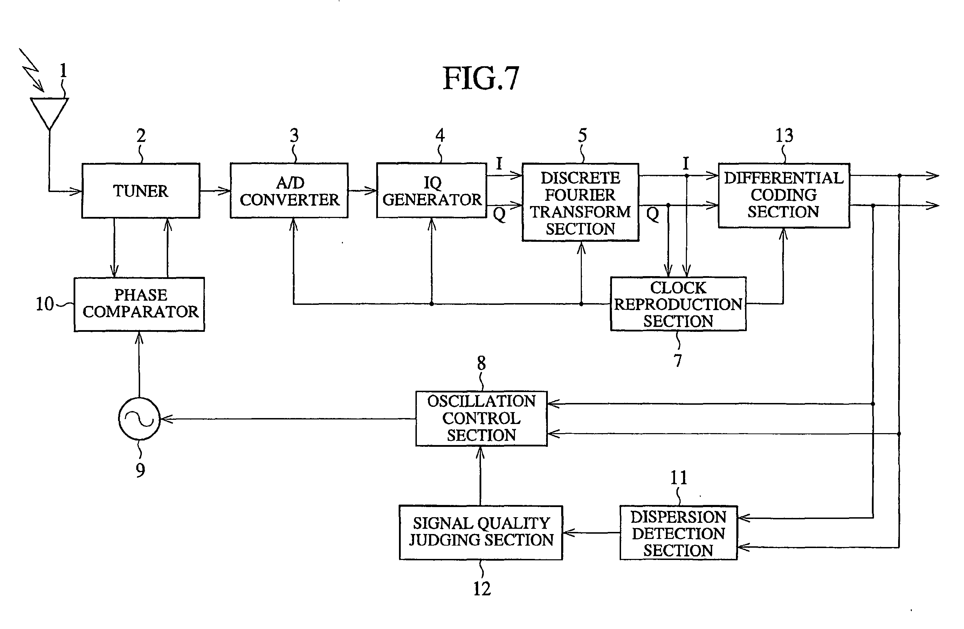

Fig. 7 is a schematic diagram showing a signal decoding device according to a second embodiment of the present invention.

For example, it shows a configuration example of a receiving device for receiving OFDM modulation signals transmitted in compliance with the DAB standard. In the figure, as the same reference numerals as those in the first embodiment indicate the same or similar portions, the explanation thereabout is omitted. Reference numeral 13 denotes a differential coding section that calculates the difference between the phase of a carrier configuring the OFDM signal and the phase of the carrier which is one OFDM-symbol before that phase from the I component data and Q component data which are frequency modulated in the discrete Fourier transform section 5 as to all the carriers, reference numeral 8 denotes an oscillator control section that controls a local oscillator 9 to vary the oscillation frequency in accordance with the phase difference of the carrier, and calculates a control amount from the mean value of the phase errors. Further, reference numeral 11 denotes a dispersion detection section that detects the dispersed state of the phase errors, which are obtained from the phases calculated beforehand, and all other portions operate just as those in the first embodiment.

The operation of the signal decoding device according to the second embodiment of the present invention is as follows.

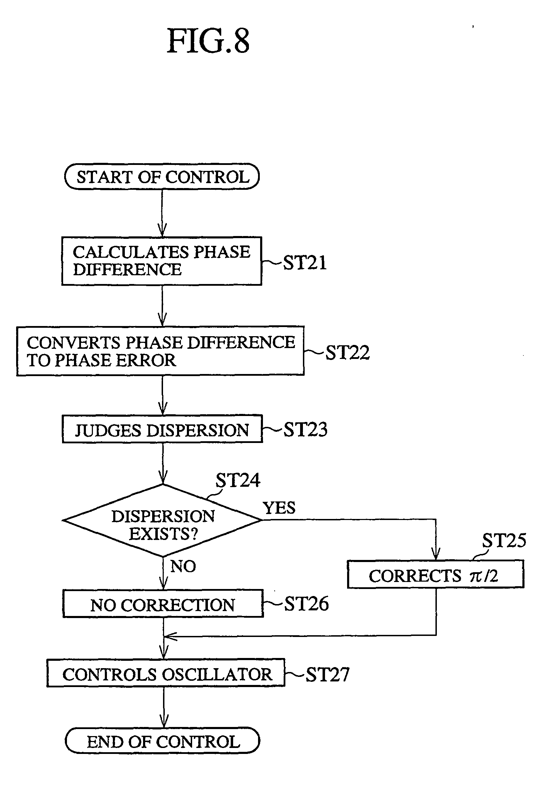

Fig. 8 is a flow chart showing an exemplary case of the control operation for receiving the DAB signals in the signal decoding device according to this embodiment.

When the control of synchronization performed in the signal receiver is started, the differential coding section 13 calculates the phase difference by use of the detected phase data input from the discrete Fourier transform section 5 (step ST21), the dispersion detection section 11 converts the phase difference from the differential coding section 13 into phase errors (step ST22), and the signal quality judging section 12 judges the dispersed state of the phase errors (step ST23).

Thereafter, when the signal quality judging section 12 checks whether there is a dispersion (step ST24), and judges that it is positive, then it instructs a certain correction control amount (for example π/2) to the oscillator control section 8 (step ST25), whereas when it judges that there is no dispersion, then it instructs no correction control (step ST26). Finally, the oscillator control section 8 terminates the control of the synchronization depending on whether there is an instruction of correction control from the dispersion detection section 11 (step ST27). By carrying out these steps at predetermined periods, the signal reception in good condition can be obtained.

As explained above, according to the second embodiment, when the signal quality judging section 12 compares the dispersed state input from the dispersion detection section 11 to the relation between the phase errors and the dispersion thereof, it can judge the signal quality, so that in the case where differential phase-modulated broadcast signals such as OFDM signals configured by a plurality of carriers are to be received, carriers necessary for those signals can be correctly received in a good state without getting into a false locked state.

### [Third Embodiment]

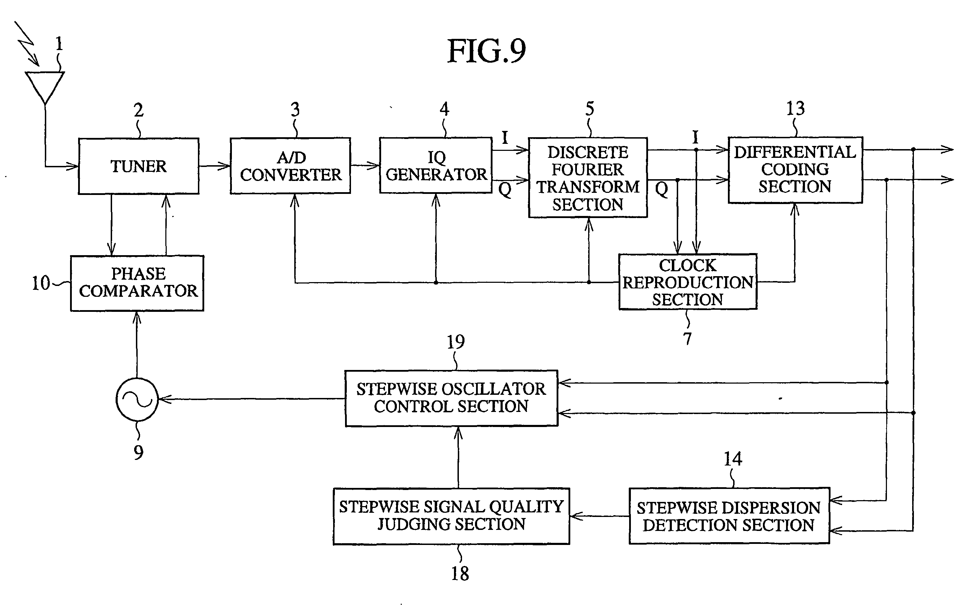

Fig. 9 is a schematic diagram showing a signal decoding device according to a third embodiment of the present invention.

For example, it shows a configuration example of a receiving device for receiving OFDM modulation signals transmitted in compliance with the DAB standard. In the figure, as the same reference numerals as those in the first and second embodiments indicate the same or similar portions, the explanation thereabout is omitted. Reference numeral 14 denotes a stepwise dispersion detection section that detects in a stepwise manner the dispersed state of the phase errors, which are calculated from the phase difference obtained in the differential coding section 13, and numeral 18 denotes a stepwise signal quality judging section that judges the quality of the decoded signal on the basis of the dispersed state detected in the dispersion detection section 14 in a stepwise manner, and outputs the result of the judgment to the stepwise oscillator control section 19.

Although the stepwise oscillator control section 19 calculates a control amount from the mean value of the phase errors, in this case, it is a stepwise oscillator control section that varies the control amount in a stepwise manner in accordance with the signal quality of the signal judged in the stepwise signal quality judging section 18, and it varies the oscillation frequency of the local oscillator 9 in accordance with the control amount fed from the stepwise oscillator control section 19.

The phase comparator 10 controls the tuner 2 so as to equalize the oscillation frequency of the local oscillator 9 and that of a local oscillator contained in the tuner 2.

The operation of the signal decoding device according to the third embodiment of the present invention is as follows.

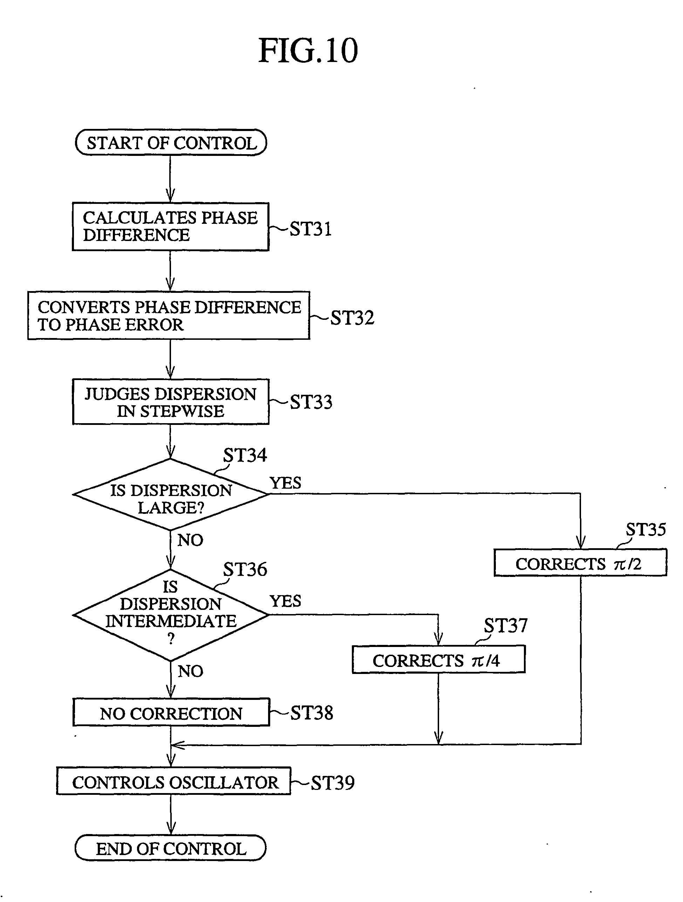

Fig. 10 is a flow chart showing an exemplary case of the control operation for receiving the DAB signals in the signal decoding device according to this embodiment.

When the control of synchronization performed in the signal receiver is started, the differential coding section 13 calculates the phase difference by use of the detected phase data input from the discrete Fourier transform section 5 (step ST31), the stepwise dispersion detection section 14 converts the phase difference from the differential coding section 13 (step ST32) into phase errors, and the stepwise signal quality judging section 18 judges the dispersed state of the phase errors (step ST33) in a stepwise manner. Thereafter, when the stepwise signal quality judging section 18 checks whether there is a large dispersion (step ST34), and judges that it is positive, then it instructs a certain correction control amount (for example π/2) to the stepwise oscillator control section 19 (step ST35).

On the other hand, when it judges that the dispersion therein is not large, but of the intermediate level, then it instructs a certain correction control amount which is different from the that of the case of a large dispersion, for example an amount that corresponds to π/4, to the stepwise oscillator control section 19 (step ST37), and further, when it judges that the dispersion therein is small in step ST36, then it instructs no correction control to the stepwise oscillator control section 19 (step ST38). Finally, the stepwise oscillator control section 19 terminates the control of the synchronization depending on whether there is an instruction of correction control from the stepwise dispersion detection section 14 (step ST39). By carrying out these steps at predetermined periods, the signal reception in good condition can be obtained.

The relation between the detected phase errors and the dispersion thereof will be as shown in Fig. 6 as indicated by the first embodiment, wherein the stepwise dispersion detection section 14 detects whether the dispersion is in such a sate, as shown in Fig. 4, that the detected phase errors largely disperse equally to the positive and negative sides from the respective broken lines, or whether in such a state as shown in Fig. 5 that some of those are smaller than the broken lines equally to the both positive and negative sides, or whether in such a state as shown in Fig. 3 that there is no dispersion thereof. In other words, the stepwise dispersion detection section 14 determines in a stepwise manner by judging in which one of the points a to c of Fig. 6 the dispserion resides.

The stepwise signal quality judging section 18 judges the signal quality in a stepwise manner in accordance with the result of the stepwise detection of the dispersed state. For example, in Fig. 6, the dispersed state at the point a indicates that the signal quality is good, at c indicates that the phase error is quite large and thus the signal quality is bad, and at b indicates that the signal quality is in the intermediate level.

The stepwise oscillator control section 19 varies the control amount in a stepwise manner on the basis of the signal quality judged in a stepwise manner. For example, it varies the control amount either to a control amount calculated based on the mean value of the phase errors, to a certain control amount (corresponding to π/2 for example), or to a half that amount (corresponding to π/4 for example).

As explained above, the signal quality is judged in a stepwise manner on the basis of the dispersed state of the detected phase errors according to the third embodiment, and the frequency and phase of the local oscillation signal used for signal decoding operation are controlled in different stages, so that the control of the receiving device can be more efficiently carried out than the second embodiment.

### [Fourth Embodiment]

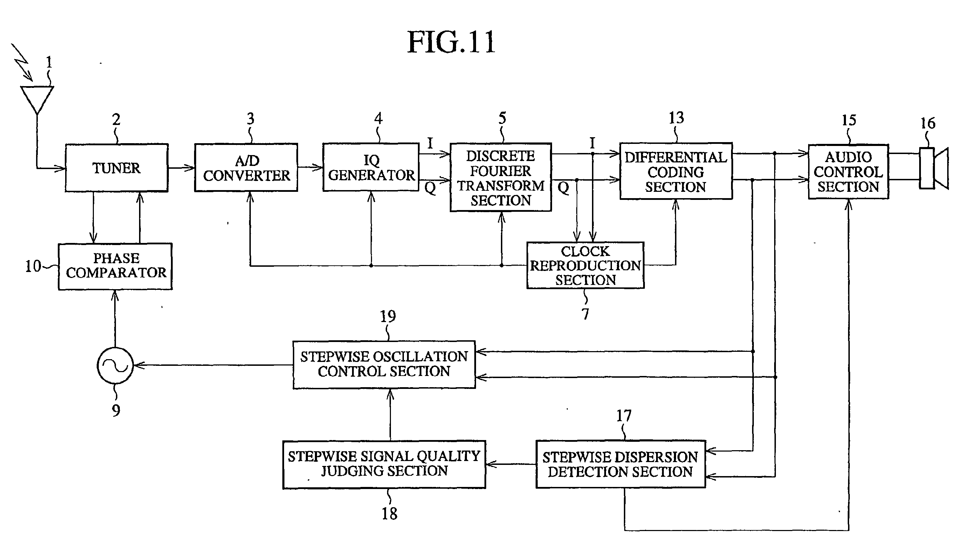

Fig. 11 is a schematic diagram showing a signal decoding device according to a fourth embodiment of the present invention, and for example, it shows a configuration example of a receiving device for receiving OFDM modulation signals transmitted in compliance with the DAB standard. In the figure, as the same reference numerals as those in the first, second and third embodiments indicate the same or similar portions; the explanation thereabout is omitted. The result of detection of the dispersed state detected in the stepwise dispersion detection section 17 in a stepwise manner is input to an audio control section 15, and the muting amount can be determined in the audio control section 15 in accordance with the detection result of the dispersed state. For example, the audio control can be performed in such a manner as to carry out muting operation only when there is dispersion as shown in Fig. 5.

The operation of the signal decoding device according to the fourth embodiment of the present invention is as follows.

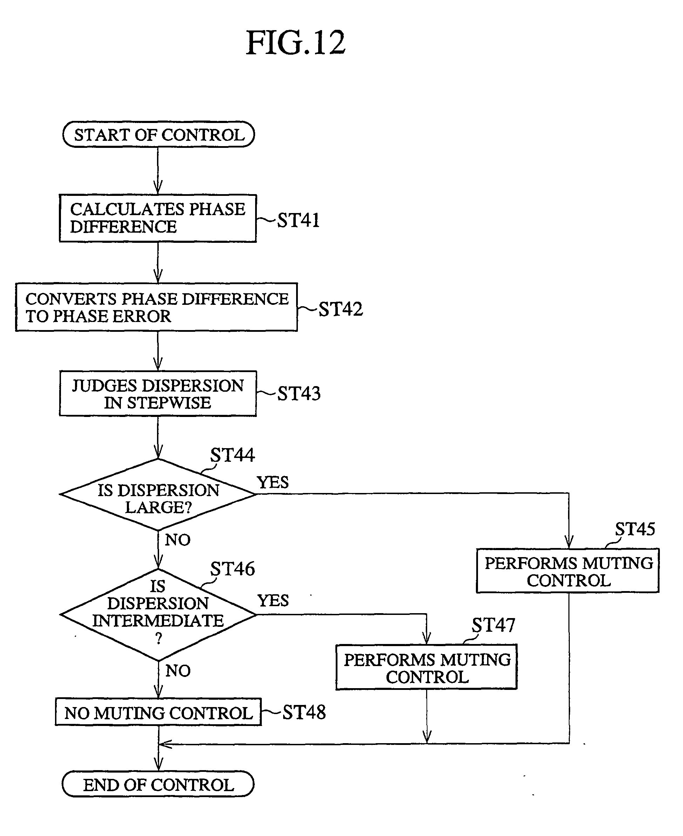

Fig. 12 is a flow chart showing an exemplary case of the control operation for receiving the DAB signals in the signal decoding device according to this embodiment.

When the control of synchronization performed in the signal receiver is started, the differential coding section 13 calculates the phase difference by use of the detected phase data input from the discrete Fourier transform section 5 (step ST41), the stepwise dispersion detection section 17 converts the phase difference from the differential coding section 13 (step ST42) into phase errors, and the stepwise signal quality judging section 18 judges the dispersed state of the phase errors (step ST43) in a stepwise manner. Thereafter, when the stepwise signal quality judging section 18 checks whether there is a large dispersion (step ST44), and judges that there is a large dispersion, then it controls the muting amount to fully reduce the acoustic volume with respect to the audio control section (step ST45).

On the other hand, when it is judged in step ST44 that the dispersion therein is not large, but of the intermediate level (step ST46), then the acoustic volume will not be fully reduced, but for a certain amount (step ST47), whereas when it is judged that there is no dispersion, then no muting control is performed (step ST48), and the volume control is terminated. By carrying out these steps at predetermined periods, a queer sound generated in accordance with the deterioration of the decoded signal can be sufficiently suppressed.

As explained above, according to the fourth embodiment, the signal quality is judged in a stepwise manner in accordance with the dispersed state of the detected phase errors, and the muting amount is controlled on the basis of the result of the judgment, so that such an effect can be obtained that a queer sound generated in accordance with the deterioration of the decoded signal is suppressed.

### [Fifth Embodiment]

Since the construction of the fifth embodiment of the present invention is same as that of the fourth embodiment, explanation thereof is omitted here. Further, as the same reference numerals as those in the first to the fourth embodiments indicate the same or similar portions, the explanation thereabout is omitted. The result of the detection of the dispersed state detected in the stepwise dispersion detection section 17 in a stepwise manner is input to the audio control section 15, and the audio control section 15 determines a control amount of high-pitch tone (high-cut amount) in accordance with the detection result of the dispersed state in different stages, so as to perform an audio control.

The operation of the signal decoding device according to the fourth embodiment of the present invention is as follows.

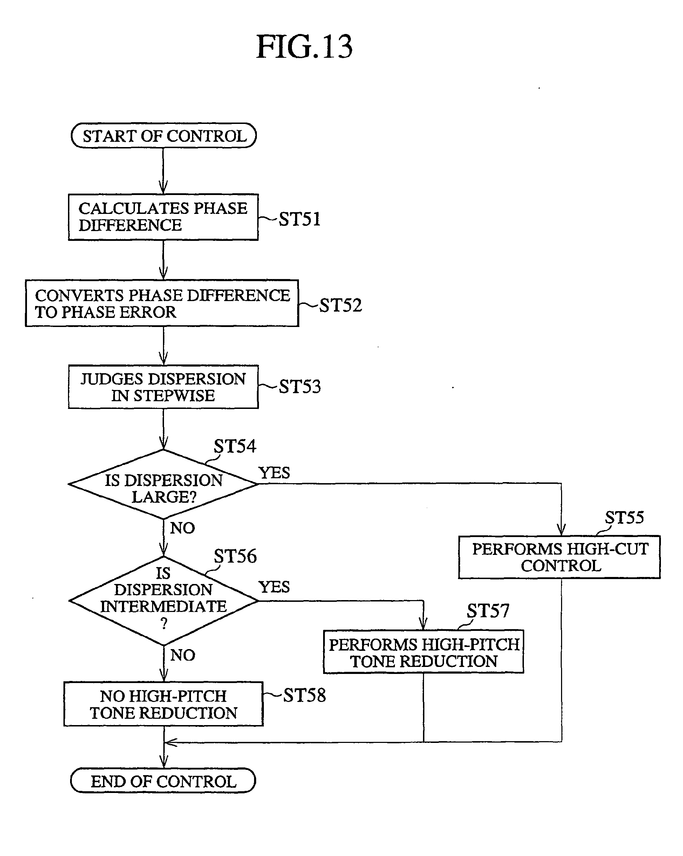

Fig. 13 is a flow chart showing an exemplary case of the control operation for receiving the DAB signals in the signal decoding device according to this embodiment.

When the control of synchronization performed in the signal receiver is started, the differential coding section 13 calculates the phase difference by use of the detected phase data input from the discrete Fourier transform section 5 (step ST51), the stepwise dispersion detection section 17 converts the phase difference from the differential coding section 13 (step ST52) into phase errors, and the stepwise signal quality judging section 18 judges the dispersed state of the phase errors (step ST53) in a stepwise manner. Thereafter, when the stepwise signal quality judging section 18 checks whether there is a large dispersion (step ST54) and judges that there is a large dispersion, then it controls to fully reduce the high-pitch tone with respect to the audio control section (step ST55).

On the other hand, when it is judged in step ST54 that the dispersion therein is not large, but of the intermediate level (step ST56), then the high-pitch tone is reduced for a certain amount (step ST57), whereas when it is judged that there is no dispersion in step ST56, then no muting control is performed with respect to the audio control section 15 (step ST58), and the control of high-cut amount is terminated. By carrying out these steps at predetermined periods, a queer sound generated in accordance with the deterioration of the decoded signal can be suppressed without muting the sound.

As explained above, according to the fifth embodiment, the signal quality is judged in a stepwise manner in accordance with the dispersed state of the detected phase errors, and the muting of the high-pitch tone is controlled based on the result of the judgment, so that such an effect can be acquired that a queer sound generated in accordance with the deterioration of the decoded signal is suppressed without muting the sound.

### Industrial Applicability

As explained heretofore, the signal decoding device and the method of controlling the signal reception by use of the signal decoding device according to the present invention are applicable to a signal decoding device and a method of controlling the signal reception therein, which requires ability to correctly receive carriers necessary for transmitting modulated signals such as OFDM signals configured by a plurality of sub-carriers in a good state, yet without getting into a false locked state.

## Claims

1. A signal decoding device comprising:
a tuner (2) adapted to convert a transmitted radio wave into a signal of predetermined medium frequency band,
an IQ generator section (4) adapted to convert the data converted by said tuner into a digital data, and to divide said digital data into a real-number signal component and an imaginary-number signal component,
a discrete Fourier transform section (5) adapted to perform Fourier transformation to the real-number signal component and the imaginary-number signal component generated in said IQ generator (4) section so as to modulate a time-mode signal to a frequency-mode signal,
a phase detection means (6', 13) adapted to detect and to output the phase of carriers, on the basis of the real-number signal component data and the imaginary-number signal component data transformed by said discrete Fourier transform section (5),
a dispersion detection section (11, 14, 17) adapted to calculate phase errors from the phases detected in said phase detection means, and to detect the dispersed state of the phase errors,
a signal quality judging section (12, 18) adapted to judge the quality of the decoded signal on the basis of the dispersed state of the phase errors detected in said dispersion detection section (11, 14, 17) and to output a certain correction control amount in case of dispersion judged, whereas no correction control amount in case of no dispersion judged,
an oscillator control section (8, 19) adapted to control a local oscillator (9) in accordance with the phase errors of the carriers, and to vary the oscillation frequency, and
a phase comparator (10) adapted to control said tuner (2) so as to equalize the oscillation frequency of said local oscillator (9) controlled by said oscillator control section (8, 19) and that of a local oscillator contained in said tuner,
wherein
said signal quality judging section (12, 18) is adapted to output the resultant value of the judgment to said oscillator control section (8).

2. Signal decoding device according to claim 1, wherein said phase detection means is a differential coding section (13) and is enabled to adopt phase differences of all carriers configuring a broadcast signal, and to calculate and output the phase difference between the phase of a carrier and that of the carrier which is one symbol before that phase on the basis of the frequency-modulated real-number signal component data and imaginary-number signal component data.

3. Signal decoding device according to claim 2, wherein said dispersion detection section (14, 17) is adapted to detect in a stepwise manner the dispersed state of the phase errors, which are calculated from the phase difference calculated in said differential coding section (13), and said signal quality judging section (18) is adapted to judge the quality of the decoded signal in a stepwise manner on the basis of the stepwise dispersed states of the phase errors detected in said dispersion detection section, and
when said oscillator control section (8, 19) is adpated to calculate a control amount from the mean value of said phase errors, to change the control amount in a stepwise manner on the basis of the resultant stepwise qualities of the judgment performed in said signal quality judging section, and to vary the oscillation frequency of said local oscillator by this control amount.

4. Signal decoding device according to one of claims 1 to 3, wherein said dispersion detection section (11, 14, 17) is adapted to output the detection result of the dispersed state detected in a stepwise manner to an audio control section (15), and said audio control section is adapted to determine the muting amount in accordance with the detection result of the stepwise dispersed state so as to perform an audio control.

5. Signal decoding device according to one of claims 1 to 3, wherein said dispersion detection section (11, 14, 17) is adapted to output the detection result of the dispersed state detected in a stepwise manner to an audio control section(15), and said audio control section is adapted to determine a control amount of high-pitch tone in accordance with the detection result of the stepwise dispersed states so as to perform an audio control.

6. A method of controlling the reception in a signal decoding device, said signal including a broadcast signal, comprising the steps of:
converting a radio wave captured by an antenna (1) into a signal of medium frequency band, forming this converted signal of medium frequency band into a digital data, dividing the digital data into a real-number signal component and an imaginary-number signal component,
performing discrete Fourier transformation to the generated real-number signal component and the imaginary-number signal component,
modulating a time-mode signal into a frequency-mode signal,
detecting and outputting the phases of carriers, as to all the carriers configuring the broadcast signal from the frequency-modulated real-number signal component data and the imaginary-number signal component data,
controlling a local oscillator (9) by an oscillator control section (8, 18) to vary the oscillation frequency, on the basis of the phase of the carriers, and
controlling the tuner (2) for equalizing the oscillation frequency of the thus controlled local oscillator and that of a local oscillator contained in the tuner,
wherein said method further comprises the steps of:
calculating phase errors from the detected phases, detecting the dispersed state of the calculated phase errors, judging the signal quality of the decoded signal from the detected dispersed state of the phase errors, and delivering the judgement result to said oscillator control section (8, 18) by outputting a certain correction control amount in case of dispersion judged, whereas no corrections control amount in case of no dispersion judged.

7. Method according to claim 6, wherein the step of detecting and outputting the phase of carriers comprises:
outputting the phase differences between the phase of a carrier and that of the carrier which is one-symbol before that phase as to all the carriers, and wherein
phase errors are calculated from the output phase differences.

8. Method according to claim 7 **characterized in that** said step of detecting the dispersed state of the phase errors calculated from the calculated phase differences is carried out in a stepwise manner,
wherein whether or not the decoded signal is of good quality is judged from this detected stepwise dispersed state of the phase errors in a stepwise manner, and
wherein said method further comprises the following steps after outputting the judgment result,
varying the control amount in a stepwise manner in accordance with the judged stepwise signal qualities, and
varying the oscillation frequency of the local oscillator from the varied control amount.

9. Method according to claim 8 **characterized in that** said step of detecting the dispersed state is carried out in a stepwise manner, wherein the judgment result of the dispersed state detected in a stepwise manner is fed to an audio control section (15), and said audio control section (15) determines a muting amount or a control amount of high-pitch tone in accordance with the detection result of the stepwise dispersed state, so as to perform an audio control.

## Patentansprüche

1. Signaldecodiervorrichtung, welche aufweist:
eine Abstimmvorrichtung (2), die ausgebildet ist zum Umwandeln einer übertragenen Funkwelle in ein Signal mit vorbestimmtem Mittelfrequenzband,
eine IQ-Generatorschaltung (4), die ausgebildet ist zum Umwandeln der von der Abstimmvorrichtung umgewandelten Daten in digitale Daten und zum Teilen der digitalen Daten in eine Signalkomponente aus reellen Zahlen und eine Signalkomponente aus imaginären Zahlen,
eine Schaltung (5) für diskrete Fourier-Transformation, die ausgebildet ist zum Durchführen einer Fourier-Transformation bei der Signalkomponente aus reellen Zahlen und der Signalkomponente aus imaginären Zahlen, die in der IQ-Generatorschaltung (4) erzeugt wurden, um ein Zeitmodussignal in ein Frequenzmodussignal zu modulieren,
eine Phasenerfassungsvorrichtung (6', 13), die ausgebildet ist zum Erfassen und zum Ausgeben der Phase von Trägern auf der Grundlage der Signalkomponentendaten aus reellen Zahlen und der Signalkomponentendaten aus imaginären Zahlen, die von der Schaltung (5) für diskrete Fourier-Transformation transformiert wurden,
eine Streuungserfassungsschaltung (11, 14, 17), die ausgebildet ist zum Berechnen von Phasenfehlern aus den in der Phasenerfassungsvorrichtung erfassten Phasen und zum Erfassen des gestreuten Zustands der Phasenfehler,
eine Signalqualitäts-Beurteilungsschaltung (12, 18), die ausgebildet ist zum Beurteilen der Qualität des decodierten Signals auf der Grundlage des in der Streuungserfassungsschaltung (11, 14, 17) erfassten, gestreuten Zustands der Phasenfehler und zum Ausgeben eines bestimmten Korrektursteuerwerts für den Fall der Beurteilung einer Streuung und keines Korrektursteuerwerts für den Fall, dass keine Streuung beurteilt wird,
eine Oszillatorsteuerschaltung (8, 19), die ausgebildet ist zum Steuern eines lokalen Oszillators (9) gemäß den Phasenfehlern der Träger und zum Verändern der Oszillationsfrequenz, und
einen Phasenkomparator (10), der ausgebildet ist zum Steuern der Abstimmvorrichtung (2) derart, dass die Oszillationsfrequenz des von der Oszillatorsteuerschaltung (8, 19) gesteuerten lokalen Oszillators (9) und die eines in der Abstimmvorrichtung enthaltenen lokalen Oszillators gleich gemacht werden,
wobei die Signalqualitäts-Beurteilungsschaltung (12, 18) ausgebildet ist zum Ausgeben des sich ergebenden Werts der Beurteilung zu der Oszillatorsteuerschaltung (8).

2. Signaldecodiervorrichtung nach Anspruch 1,
bei der die Phasenerfassungsvorrichtung eine Differenzcodierschaltung (13) ist und imstande ist zum Annehmen von Phasendifferenzen aller Träger, die ein Rundfunksignal bilden, und zum Berechnen und Ausgeben der Phasendifferenz zwischen der Phase eines Trägers und der des Trägers, der ein Symbol vor dieser Phase ist, auf der Grundlage der frequenzmodulierten Signalkomponentendaten aus reellen Zahlen und Signalkomponentendaten aus imaginären Zahlen.

3. Signaldecodiervorrichtung nach Anspruch 2,
bei der die Streuungserfassungsschaltung (14, 17) ausgebildet ist zum schrittweisen Erfassen des gestreuten Zustands der Phasenfehler, die aus der in der Differenzcodierschaltung (13) berechneten Phasendifferenz berechnet sind, und
die Signalqualitäts-Beurteilungsschaltung (18) ausgebildet ist zum schrittweisen Beurteilen der Qualität des decodierten Signals auf der Grundlage der schrittweise gestreuten Zustände der in der Streuungserfassungsschaltung erfassten Phasenfehler und
die Oszillatorsteuerschaltung (8, 19) ausgebildet ist zum Berechnen eines Steuerwerts aus dem Mittelwert der Phasenfehler, zum schrittweisen Ändern des Steuerwerts auf der Grundlage der sich ergebenden schrittweisen Qualitäten der in der Signalqualitäts-Beurteilungsschaltung durchgeführten Beurteilung und zum Verändern der Oszillationsfrequenz des lokalen Oszillators um diesen Steuerwert.

4. Signaldecodiervorrichtung nach einem der Ansprüche 1 bis 3, bei der die Streuungserfassungsschaltung (11, 14, 17) ausgebildet ist zum Ausgeben des Erfassungsergebnisses des schrittweise erfassten gestreuten Zustands zu einer Audiosteuerschaltung (15) und
die Audiosteuerschaltung ausgebildet ist zum Bestimmen des Dämpfungswerts gemäß dem Erfassungsergebnis des schrittweise gestreuten Zustands derart, dass eine Audiosteuerung durchgeführt wird.

5. Signaldecodiervorrichtung nach einem der Ansprüche 1 bis 3, bei der die Streuungserfassungsschaltung (11, 14, 17) ausgebildet ist zum Ausgeben des Erfassungsergebnisses des schrittweise erfassten gestreuten Zustands zu einer Audiosteuerschaltung (15) und
die Audiosteuerschaltung ausgebildet ist zum Bestimmen eines Steuerwerts eines Hochtons gemäß dem Erfassungsergebnis der schrittweise gestreuten Zustände, um eine Audiosteuerung durchzuführen.

6. Verfahren zum Steuern des Empfangs in einer Signaldecodiervorrichtung, welches Signal ein Rundfunksignal enthält, aufweisend die Schritte:
Umwandeln einer durch eine Antenne (1) erfassten Funkwelle in ein Signal eines Mittelfrequenzbands, Formen dieses umgewandelten Signals eines Mittelfrequenzbands in digitale Daten,
Teilen der digitalen Daten in eine Signalkomponente aus reellen Zahlen und eine Signalkomponente aus imaginären Zahlen,
Durchführen einer diskreten Fourier-Transformation bei den erzeugten Signalkomponenten aus reellen Zahlen und aus imaginären Zahlen,
Modulieren eines Zeitmodussignals in ein Frequenzmodussignal,
Erfassen und Ausgeben der Phasen von Trägern bei allen das Rundfunksignal bildenden Trägern aus den frequenzmodulierten Signalkomponentendaten aus reellen Zahlen und Signalkomponentendaten aus imaginären Zahlen,
Steuern eines lokalen Oszillators (9) durch eine Oszillatorsteuerschaltung (8, 18), um die Oszillationsfrequenz zu verändern, auf der Grundlage der Phase der Träger, und
Steuern der Abstimmvorrichtung (2), um die Oszillationsfrequenz des so gesteuerten lokalen Oszillators und die eines in der Abstimmvorrichtung enthaltenen, lokalen Oszillators einander gleich zu machen,
wobei das Verfahren weiterhin die Schritte aufweist:
Berechnen von Phasenfehlern aus den erfassten Phasen, Erfassen des gestreuten Zustands der berechneten Phasenfehler, Beurteilen der Signalqualität des decodierten Signals aus dem erfassten gestreuten Zustand der Phasenfehler und Liefern des Beurteilungsergebnisses zu der Oszillatorsteuerschaltung (8, 18) durch Ausgeben eines bestimmten Korrektursteuerwerts in dem Fall einer beurteilten Streuung und keines Korrektursteuerwerts in dem Fall, dass keine Streuung beurteilt wird.

7. Verfahren nach Anspruch 6, bei dem der Schritt des Erfassens und Ausgebens der Phase von Trägern aufweist:
Ausgeben der Phasendifferenzen zwischen der Phase eines Trägers und der des Trägers, der ein Symbol vor dieser Phase ist, für alle Träger, und wobei
Phasenfehler aus den ausgegebenen Phasendifferenzen berechnet werden.

8. Verfahren nach Anspruch 7, **dadurch gekennzeichnet, dass** der Schritt des Erfassens des gestreuten Zustands der aus den berechneten Phasendifferenzen berechneten Phasenfehler schrittweise durchgeführt wird,
wobei anhand dieses erfassten schrittweisen gestreuten Zustands der Phasenfehler schrittweise beurteilt wird, ob das decodierte Signal von guter Qualität ist oder nicht, und
wobei das Verfahren weiterhin nach dem Ausgeben des Beurteilungsergebnisses die folgenden Schritte aufweist:
schrittweises Verändern des Steuerwerts gemäß den beurteilten schrittweisen Signalqualitäten und
Verändern der Oszillationsfrequenz des lokalen Oszillators anhand des veränderten Steuerwerts.

9. Verfahren nach Anspruch 8, **dadurch gekennzeichnet, dass** der Schritt des Erfassens des gestreuten Zustands schrittweise durchgeführt wird, wobei das Beurteilungsergebnis des schrittweise erfassten gestreuten Zustands zu einer Audiosteuerschaltung (15) geführt wird und die Audiosteuerschaltung (15) einen Dämpfungswert oder einen Steuerwert von Hochton bestimmt gemäß dem Erfassungsergebnis des schrittweise gestreuten Zustands, um eine Audiosteuerung durchzuführen.

## Revendications

1. Dispositif de décodage de signaux comprenant :
- un syntoniseur (2) conçu de manière à convertir une onde radio émise en un signal de bande de fréquence moyenne prédéterminée,
- une section de générateur IQ (4) conçue de manière à convertir les données converties par ledit syntoniseur en données numériques, et à diviser lesdites données numériques en une composante de signal réelle et en une composante de signal imaginaire,
- une section de transformée de Fourier discrète (5) conçue de manière à exécuter une transformée de Fourier sur la composante de signal réelle et sur la composante de signal imaginaire générées dans ladite section de générateur IQ (4) afin de moduler un signal en mode temporel en un signal en mode fréquentiel,
- des moyens de détection de phase (6', 13) conçus de manière à détecter et à délivrer en sortie la phase des porteuses, sur la base des données de la composante de signal réelle et des données de la composante de signal imaginaire transformées par ladite section de transformée de Fourier discrète (5),
- une section de détection de dispersion (11, 14, 17) conçue de manière à calculer des erreurs de phase à partir des phases détectées dans lesdits moyens de détection de phase, et à détecter l'état dispersé des erreurs de phase,
- une section d'estimation de la qualité du signal (12, 18) conçue de manière à estimer la qualité du signal décodé sur la base de l'état dispersé des erreurs de phase détectées dans ladite section de détection de dispersion (11, 14, 17) et à délivrer en sortie une certaine quantité de commande de correction dans le cas où l'on estime qu'il y a une dispersion, et aucune quantité de commande de correction dans le cas où l'on estime qu'il n'y a pas de dispersion,
- une section de commande d'oscillateur (8, 19) conçue de manière à commander un oscillateur local (9) selon les erreurs de phase des porteuses, et à faire varier la fréquence d'oscillation, et
- un comparateur de phase (10) conçu de manière à commander ledit syntoniseur (2) afin de rendre égale la fréquence d'oscillation dudit oscillateur local (9) commandé par ladite section de commande d'oscillateur (8, 19), à celle d'un oscillateur local contenu dans ledit syntoniseur, dans lequel
- ladite section d'estimation de la qualité du signal (12, 18) est conçue de manière à délivrer en sortie la valeur résultante de l'estimation à ladite section de commande d'oscillateur (8).

2. Dispositif de décodage de signaux selon la revendication 1, dans lequel lesdits moyens de détection de phase sont une section de codage différentiel (13) et sont capables d'adopter des différences de phase de toutes les porteuses qui configurent un signal d'émission, et de calculer et de délivrer en sortie la différence de phase entre la phase d'une porteuse et celle de la porteuse qui est à un symbole avant cette phase sur la base des données de la composante de signal réelle et des données de la composante de signal imaginaire modulées en fréquence.

3. Dispositif de décodage de signaux selon la revendication 2, dans lequel ladite section de détection de dispersion (14, 17) est conçue de façon à détecter d'une manière par paliers l'état dispersé des erreurs de phase qui sont calculées à partir de la différence de phase calculée dans ladite section de codage différentiel (13), et
ladite section d'estimation de la qualité du signal (18) est conçue de manière à estimer la qualité du signal décodé d'une manière par paliers sur la base des états dispersés par paliers des erreurs de phase détectées dans ladite section de détection de dispersion, et
ladite section de commande d'oscillateur (8, 19) est conçue de manière à calculer une quantité de commande à partir de la valeur moyenne desdites erreurs de phase, à modifier la quantité de commande d'une manière par paliers sur la base des qualités par paliers résultantes de l'estimation exécutée dans ladite section d'estimation de la qualité du signal, et à faire varier de cette quantité de commande la fréquence d'oscillation dudit oscillateur local.

4. Dispositif de décodage de signaux selon l'une quelconque des revendications 1 à 3, dans lequel ladite section de détection de dispersion (11, 14, 17) est conçue de manière à délivrer en sortie le résultat de la détection de l'état dispersé détecté d'une manière par paliers à une section de commande audio (15), et ladite section de commande audio est conçue de manière à déterminer la quantité de silencieux selon le résultat de détection de l'état dispersé par paliers de façon à exécuter une commande audio.

5. Dispositif de décodage de signaux selon l'une quelconque des revendications 1 à 3, dans lequel ladite section de détection de dispersion (11, 14, 17) est conçue de manière à délivrer en sortie le résultat de la détection de l'état dispersé détecté d'une manière par paliers à une section de commande audio (15), et ladite section de commande audio est conçue de manière à déterminer une quantité de commande de tonalité aiguë selon le résultat de détection des états dispersés par paliers de façon à exécuter une commande audio.

6. Procédé de commande de réception dans un dispositif de décodage de signaux, ledit signal incluant un signal d'émission, comprenant les étapes consistant à:
- convertir une onde radio captée par une antenne (1) en un signal de bande de fréquence moyenne,
- transformer ce signal converti de bande de fréquence moyenne en données numériques,
- diviser les données numériques en une composante de signal réelle et en une composante de signal imaginaire,
- exécuter une transformée de Fourier discrète sur la composante de signal réelle et sur la composante de signal imaginaire générées,
- moduler un signal de mode temporel en un signal de mode fréquentiel,
- détecter et délivrer en sortie les phases des porteuses, pour ce qui est de toutes les porteuses qui configurent le signal d'émission, à partir des données de la composante de signal réelle et des données de la composante de signal imaginaire modulées en fréquence,
- commander un oscillateur local (9) par une section de commande d'oscillateur (8, 18) de manière à faire varier la fréquence d'oscillation, sur la base de la phase des porteuses, et
- commander le syntoniseur (2) de manière à rendre égale la fréquence d'oscillation de l'oscillateur local ainsi commandé, à celle d'un oscillateur local contenu dans le syntoniseur, dans lequel ledit procédé comprend en outre les étapes consistant à :
- calculer des erreurs de phase à partir des phases détectées, détecter l'état dispersé des erreurs de phase calculées, estimer la qualité de signal du signal décodé à partir de l'état dispersé détecté des erreurs de phase, et fournir le résultat de l'estimation à ladite section de commande d'oscillateur (8, 18) en délivrant en sortie une certaine quantité de commande de correction dans le cas où l'on estime qu'il y a une dispersion, et aucune quantité de commande de correction dans le cas où l'on estime qu'il n'y a pas de dispersion.

7. Procédé selon la revendication 6, dans lequel l'étape consistant à détecter et à délivrer en sortie la phase des porteuses comprend l'étape consistant à :
délivrer en sortie les différences de phase entre la phase d'une porteuse et celle de la porteuse qui est à un symbole avant cette phase pour ce qui est de toutes les porteuses, et dans lequel
des erreurs de phase sont calculées à partir des différences de phase délivrées en sortie.

8. Procédé selon la revendication 7, **caractérisé en ce que** ladite étape consistant à détecter l'état dispersé des erreurs de phase calculées à partir des différences de phase calculées, est effectuée d'une manière par paliers,
dans lequel on estime si, oui ou non, le signal décodé est de bonne qualité à partir de cet état dispersé par paliers détecté des erreurs de phase d'une manière par paliers, et
dans lequel ledit procédé comprend en outre, après avoir délivré en sortie le résultat de l'estimation, les étapes suivantes consistant à :
faire varier la quantité de commande d'une manière par paliers selon les qualités estimées du signal par paliers, et
faire varier la fréquence d'oscillation de l'oscillateur local à partir de la quantité de commande qui a varié.

9. Procédé selon la revendication 8, **caractérisé en ce que** ladite étape consistant à détecter l'état dispersé est effectuée d'une manière par paliers, dans lequel le résultat de l'estimation de l'état dispersé détecté d'une manière par paliers est transmis à une section de commande audio (15), et ladite section de commande audio (15) détermine une quantité de silencieux ou une quantité de commande de tonalité aiguë selon le résultat de la détection de l'état dispersé par paliers, de manière à exécuter une commande audio.
